(19) Europäisches Patentamt
European Patent Office
Office européen des brevets

(11) **EP 2 747 086 A1**

(12) **EUROPEAN PATENT APPLICATION**

(43) Date of publication:
25.06.2014 Bulletin 2014/26

(51) Int Cl.:
*G11C 19/08* [(2006.01)]

(21) Application number: 12199318.2

(22) Date of filing: 24.12.2012

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Johannes Gutenberg-Universität Mainz 55122 Mainz (DE)**

(72) Inventors:
• **Kläui, Matthias 55122 Mainz (DE)**
• **Kim, June Seo 55128 Mainz (DE)**

(74) Representative: **HOFFMANN EITLE Patent- und Rechtsanwälte Arabellastrasse 4 81925 München (DE)**

(54) **Magnetic device switchable by magnetic domain wall motion and method of operating the device**

(57) The invention relates to a magnetic device switchable by magnetic domain wall motion. The magnetic device comprises a magnetic element (2), wherein, in operation of the magnetic device, a plurality of magnetic domains (4) are present in the magnetic element (2), the magnetic domains (4) are arranged adjacent to each other, the magnetisations of the magnetic domains (4) are oriented so that the magnetisation directions are aligned parallel to a plane, the magnetisations of adjacent magnetic domains (4) are oriented in different directions from each other, and adjacent magnetic domains (4) are separated from each other by a magnetic domain wall (6). The magnetic device further comprises a magnetic pulse application device (10) which is configured to apply magnetic field pulses to at least a portion of the magnetic element (2) in a direction perpendicular to the plane. Further, the invention relates to a method of operating this magnetic device, the method comprising the step of applying one or more magnetic field pulses to the at least a portion of the magnetic element (2) in the direction perpendicular to the plane.

Fig. 1

EP 2 747 086 A1

## Description

Field of the Invention

According to a first aspect, the invention relates to a magnetic device switchable by magnetic domain wall motion, the magnetic device comprising a magnetic element. According to a second aspect, the invention relates to a method of operating the magnetic device.

Background Art

Recently, magnetic devices, such as magnetic memory and/or logic devices, magnetic sensor devices and magnetic shift registers, exploiting the properties of magnetic domain walls in magnetic materials have been proposed. In these devices, the magnetic moment or magnetisation of the magnetic domains and/or the magnetic domain walls is used to store data and/or to perform logic operations and/or to sense magnetic fields.

US-B-6,834,005 discloses a system for a magnetic shift register. The magnetic shift register comprises a data track formed of a fine wire or strip of material made of ferromagnetic material. The wire can be magnetised in small sections in one direction or another. The magnetic moment of magnetic domains in the data track is used to store data.

A magnetic memory device in which magnetic domains are used to store information either in tall columns of magnetic material arranged perpendicularly on the surface of a silicon wafer (termed "vertical racetrack") or in magnetic material arranged in an elongated structure in the plane of the surface (termed "horizontal racetrack") is disclosed in the journal article "Magnetic Domain-Wall Racetrack Memory" by Stuart S.P. Parkin et al. (Science 320, 190 [2008], including supporting online material as supplementary information [http://www.sciencemag.org/content/suppl/2008/04/10/320.5873. 190.DC1.html]).

For an efficient and reliable operation of such magnetic devices, a controlled motion of domain walls separating adjacent magnetic domains, thereby switching between different states of the device, is required. To date, two main approaches for achieving such domain wall motion have been proposed, namely the application of external in-plane magnetic fields and the injection of spin-polarised electric currents.

In the magnetic shift register disclosed in US-B-6,834,005, an electric current is applied to the data track to move the magnetic domains along the track, in the direction of the electric current, past reading or writing elements or devices. In a magnetic material with domain walls, a current passed across the domain wall moves the domain wall in the direction of the current flow. As the current passes through a domain, it becomes spin-polarised. When this spin-polarised current passes into the next domain across a domain wall it exerts a spin torque. This spin torque moves the domain wall.

While the above-mentioned approach of current-induced domain wall motion due to the spin torque effect allows for a synchronous motion of multiple domains and domain walls, the high current densities required (approximately $10^{11}$ A/m$^2$ to $10^{12}$ A/m$^2$) cause problems, such as Joule heating due to Ohmic losses, as is disclosed in the journal articles "Analytic expression for the temperature of the current-heated nanowire for the current-induced domain wall motion" by C.-Y. You et al. (Applied Physics Letters 89, 222513 [2006]) and "Temperature increment in a current-heated nanowire for current-induced domain wall motion with finite thickness insulator layer" by C.-Y. You et al. (Applied Physics Letters 91, 022507 [2007]). For example, passing a current with a current density of $10^{12}$ A/m$^2$ through a permalloy (NiFe) nanowire can result in device temperatures of approximately 500 °C, which is close to the Curie temperature of permalloy, and can generate irreversible structural damage. Furthermore, in order to inject the current, the device has to be electrically contacted during every part of the operation.

The approach of applying external in-plane magnetic fields, i.e., magnetic fields with a direction in the plane in which the magnetisations of the magnetic domains lie, provides the advantage over current-induced domain wall motion that no high current densities are required and no electrical contacts are necessary for part of the operation, since magnetic fields can be applied without electrical connection. A device using this approach is proposed in WO-A-2007/132174.

However, this approach poses problems in that in-plane magnetic fields favour one in-plane magnetisation direction and thus move adjacent domain walls in opposite directions, as is disclosed in the journal article "Selective domain wall depinning by localized Oersted fields and Joule heating" by D. Ilgaz et al. (Applied Physics Letters 93, 132503 [2008]). Therefore, no synchronous motion of a plurality of domain walls in the same direction can be achieved. Moreover, it is difficult to generate homogenous in-plane magnetic fields.

Further, the domain wall velocity, which determines the operating speed of the above magnetic devices, is limited for domain wall motion driven by externally applied in-plane magnetic fields. Specifically, the domain wall velocity initially increases with increasing in-plane magnetic field strength but significantly drops above a certain threshold field strength, the so-called "Walker threshold field", as is disclosed in the book chapter "Domain-Wall Dynamics in Nanowires and Nanostrips" by A. Thiaville et al. in "Spin Dynamics in Confined Magnetic Structures III" (Springer, 2006).

In order to enhance the achievable domain wall velocity and push the Walker threshold field to higher field strengths, it has been proposed in the journal article "Remarkable enhancement of domain-wall velocity in magnetic nanostripes" by J-Y. Lee et al. (Applied Physics Letters 91, 122513 [2007]) to use a magnetic underlayer with strong perpendicular magnetic anisotropy underneath a magnetic element in which magnetic domains and domain walls are formed. In this journal article, a suppression of the domain wall velocity breakdown is observed as the Walker threshold field is pushed to higher values and this is attributed to the prevention of the nucleation of anti-vortex or vortex walls at the edges of the magnetic element by a stray field resulting from the magnetic underlayer.

However, so far, no synchronous motion of multiple domain walls using in-plane magnetic fields has been achieved, rendering this approach unsuitable for multiple-domain-wall-based magnetic devices.

Summary of the Invention

Accordingly, it is an object of the present invention to provide a magnetic device switchable by magnetic domain wall motion which allows for a controlled and reliable motion of magnetic domain walls. Moreover, the invention aims to provide a method of operating this device.

These goals are achieved by a magnetic device with the technical features of claim 1 and a method with the technical features of claim 15. Preferred embodiments of the invention follow from the dependent claims.

According to the first aspect, the present invention provides a magnetic device switchable by magnetic domain wall motion. The magnetic device comprises a magnetic element and a magnetic pulse application device. In operation of the magnetic device, a plurality of magnetic domains are present in the magnetic element, the magnetic domains are arranged adjacent to each other, the magnetisations of the magnetic domains are oriented so that the magnetisation directions are aligned parallel to a plane, the magnetisations of adjacent magnetic domains are oriented in different directions from each other, and adjacent magnetic domains are separated from each other by a magnetic domain wall. The magnetic pulse application device is configured to apply magnetic field pulses to at least a portion of the magnetic element in a direction perpendicular to the plane, i.e., the plane along which the magnetisation directions are aligned.

The magnetic device may be a magnetic memory and/or logic device, a magnetic sensor device, a magnetic shift register or the like. The expression "switchable by magnetic domain wall motion" defines that the magnetic device can be switched, i.e., manipulated, changed or altered, between different states of the device by magnetic domain wall motion. The magnetic device may be configured so that it can be switched from a first state into a second state by magnetic domain wall motion. The magnetic device may have more than two possible states, wherein the device can be switched between the possible states by magnetic domain wall motion.

The magnetic element may be shaped or formed so that at least one dimension of the magnetic element, i.e., an extension of the magnetic element in at least one direction, is larger than other dimensions of the magnetic element, i.e., extensions of the magnetic element in other directions.

The magnetic element may be plate-shaped or strip-shaped, i.e., have a plate-like or strip-like shape, i.e., a shape, the lateral dimensions or extensions of which along a plane are larger than the dimension or extension thereof in a direction perpendicular to the plane, i.e., a thickness direction of the magnetic element, at any point of the plane, said perpendicular dimension or extension not having to be consistent along the plane.

The magnetic element may be an elongate magnetic element. The expression "elongate magnetic element" defines a magnetic element with an elongated geometry, i.e., a magnetic element with a length that is larger than a width and a thickness of the magnetic element.

The magnetic domains may be arranged adjacent to each other along the length of the magnetic element.

In operation of the magnetic device, i.e., when the device is in an operational state, i.e., a state which allows operation, e.g., switching by magnetic domain wall motion, thereof, a plurality of magnetic domains are present in the magnetic element, as detailed above. The magnetic device may be configured so that the magnetic domains as specified above are permanently present in the magnetic element. The magnetic device may be configured so that, before operation of the magnetic device, the magnetic domains are formed in the magnetic element, e.g., by a magnetisation switching device, which will be described in detail below, and/or the magnetic pulse application device, for example, when the magnetic device is turned on.

The magnetic element may be made of one or more magnetic, e.g., ferromagnetic, materials, e.g., ferromagnetic metals, such as Fe, Ni, Co, NiFe (permalloy), CoFe etc. In particular, the magnetic element may be homogeneously formed of a single magnetic material. Alternatively, the magnetic element may be formed of a plurality of different magnetic materials, e.g., in the form of a multilayer structure. In such a multilayer structure, two or more layers of magnetic and/or non-magnetic materials may be arranged along a thickness direction of the magnetic element. For example, a Co/Pt two-layer structure, comprising a magnetic Co layer and a non-magnetic Pt layer arranged on top of each other, may be used for the magnetic element.

The magnetic element may be a magnetic wire, a magnetic strip, a magnetic bar or the like.

The magnetic device may comprise a plurality of substantially identical or different magnetic elements, e.g., a plurality of substantially identical or different elongate magnetic elements.

The magnetisations of the magnetic domains are oriented so that the magnetisation directions are aligned parallel to a plane. The expression "parallel to a plane" defines that the magnetisations of the magnetic domains are oriented so that the magnetisation directions are aligned parallel to a common plane, i.e., the same plane. The magnetisation directions of all of the magnetic domains present in the magnetic element are aligned parallel to the same plane. The plane may be parallel to one or more of the major axes of the magnetic element.

The magnetisations of adjacent magnetic domains may be oriented in opposite directions to each other.

The magnetic pulse application device is configured to apply magnetic field pulses to at least a portion of the magnetic element or the entire magnetic element in a direction perpendicular to the plane, i.e., so that the magnetic field direction of the pulse is aligned perpendicular to the plane. In one embodiment, the magnetisations of the magnetic domains may be arranged in-plane, i.e., in a plane (or parallel to a plane) perpendicular to a thickness direction of the magnetic element. In this case, the magnetic pulse application device is configured to apply magnetic field pulses in a transverse or out-of-plane direction, i.e., in a direction parallel to the thickness direction of the magnetic element.

In another embodiment, the magnetisations of the magnetic domains are oriented out-of-plane, i.e., so that the magnetisation directions are aligned parallel to the thickness direction of the magnetic element. In this case, the magnetic pulse application device is configured to apply magnetic field pulses in an in-plane direction, i.e., a direction perpendicular to the thickness direction of the magnetic element.

In one embodiment, the magnetic pulse application device is formed by a pair of parallel magnetic strip lines or the like arranged on opposite sides of the magnetic element. The parallel magnetic strip lines or the like may be arranged so as to extend along the length of the magnetic element. By passing current pulses through the two magnetic strip lines in opposite directions, a magnetic field pulse can be applied to the magnetic element in a direction perpendicular to the plane of the magnetisation directions.

The magnetic element may include two magnetic domains with a magnetic domain wall formed therebetween. Such a domain configuration could be used, for example, for a magnetic sensor device for detecting a magnetic field or magnetic field component in a direction perpendicular to the plane of the magnetisation directions of the domains. Further, such a domain configuration could be used, for example, for a magnetic memory device, e.g., a 1 bit memory device. Alternatively, more than two magnetic domains may be present in the magnetic element, wherein a respective magnetic domain wall is formed between adjacent magnetic domains, so that a plurality of magnetic domain walls are present in the magnetic element.

The magnetic domain wall or walls may be a transverse magnetic domain wall or walls or a Néel or Bloch domain wall or walls. In particular, for an in-plane orientation of the magnetisations of the magnetic domains, the magnetic domain wall or walls may be a transverse magnetic domain wall or walls and, for an out-of-plane orientation of the magnetisations of the magnetic domains, the magnetic domain wall or walls may be a Néel or Bloch wall or walls. A transverse wall is formed if the magnetisation rotates in the plane perpendicular to the thickness of the magnetic element. In a Bloch Wall, the magnetisation rotates in the plane perpendicular to the length of the magnetic element and in a Néel wall, the magnetisation rotates in the plane parallel to the length of the magnetic element and parallel to the thickness of the magnetic element. These domain wall types are discussed and defined, for example, in the journal article "Current-induced domain wall motion in nanoscale ferromagnetic elements" by O. Boulle et al. (Materials Science and Engineering R 72, 159 [2011]).

A plurality of magnetic domain walls may be arranged in the magnetic element so that adjacent or neighbouring domain walls have opposite spin structures to each other, e.g., spin structures with opposite rotation directions of the magnetisations in the domain walls to each other. For the case of transverse domain walls, adjacent or neighbouring domain walls may have opposite chiralities to each other, meaning that the magnetisation components in the domain walls perpendicular to the length and the thickness of the magnetic element point in opposite directions to each other. For the case of Néel or Bloch domain walls, adjacent or neighbouring domain walls may have spin structures with opposite rotation directions of the magnetisations in the domain walls to each other, i.e., clockwise and counterclockwise rotation directions viewed in a direction perpendicular to the plane of rotation.

Herein, the term "magnetic field pulse" defines the application of a magnetic field for a limited period of time. In the application of the magnetic field pulse, the magnetic field strength is increased from zero to a desired value, i.e., the amplitude of the pulse, in a first period of time, i.e., the rise time of the pulse, maintained at the desired value for a second period of time, i.e., the dwell time or duration of the pulse, and decreased from the desired value to zero in a third period of time, i.e., the fall time of the pulse.

The magnetic field strength may be monotonously increased during the rise time of the pulse and/or monotonously decreased during the fall time of the pulse. In one embodiment, the magnetic field is linearly increased in time during the rise time of the pulse and/or linearly decreased during the fall time of the pulse. The magnetic field strength may be maintained at a substantially constant level for a predetermined period of time during the rise time and/or the fall time of the pulse, so as to form a "plateau" in the time profile of the pulse in the rise time and/or the fall time. One or more of such plateaus of different or the same duration may be present in the rise time and/or the fall time of the pulse.

The dynamic magnetic behaviour of domain walls in an applied magnetic field is governed by the Landau-Lifshitz equation:

$$\frac{\partial M}{\partial t} = -\gamma M \times H_{\text{eff}} + \frac{\alpha \gamma}{Ms} M \times (M \times H_{\text{eff}})$$

where $\gamma$ is the gyromagnetic ratio, $M$ is the vector of the local magnetisation, $H_{\text{eff}}$ is the vector of the effective magnetic field, t is the time and $\alpha$ is a damping constant, as is detailed, for example, in the journal article "Numerical investigation of spin-torque using the Heisenberg model" by C. Schieback et al. (Eur. Phys. J. B 59, 429-433 [2007]). The right hand side of the Landau-Lifshitz equation consists of two terms. The first of these terms gives rise to a precession of the magnetic moment around the effective magnetic field and the second of these terms causes an alignment of the magnetic moment with the direction of the effective magnetic field.

As has been detailed above, the magnetic device of the invention is configured so that magnetic field pulses are applied in a direction perpendicular to the plane of the magnetisation directions in the magnetic domains. For such a geometry of the applied field, the precession around the applied field direction leads to a counterclockwise rotation of the magnetisation in a domain wall. In this way, the domain wall is moved along the length of the magnetic element.

The damping torque, i.e., the torque caused by the second term on the right hand side of the Landau-Lifshitz equation, pulls the magnetisation of the domain wall in the direction of the applied field, i.e., out of the plane of the magnetisation directions in the magnetic domains. The resulting magnetisation in this direction generates a demagnetisation field which is also oriented in the direction pointing out of the plane of the magnetisation directions in the magnetic domains, but has a direction opposite to that of the magnetisation resulting from the influence of the damping torque. This demagnetisation field leads to a precession of the magnetisation around it, wherein the precession direction is clockwise, i.e., opposite to that of the precession around the applied field direction.

Finally, the damping caused by the demagnetisation field will pull the magnetisation back into the plane of the magnetisation directions in the magnetic domains. Therefore, the domain wall will stop moving when a new equilibrium state is reached, i.e., when the precession and damping torques are equivalent and cancel each other. At this time, the domain wall has moved to a new position.

Therefore, the magnetic device of the invention allows for a controlled and reliable motion of magnetic domain walls in the magnetic element to be achieved. In particular, a plurality of magnetic domain walls can be simultaneously moved in the same direction, without any annihilation of adjacent domain walls, thereby enabling synchronous multiple domain wall motion, i.e., a simultaneous motion of multiple domain walls in the same direction and with the same velocity. Moreover, the domain wall velocity is not restricted by the Walker threshold field, as is the case for magnetic fields applied in the plane of the domain magnetisations, so that a high domain wall velocity and thus a high operating speed of the magnetic device can be achieved.

Further, since no current has to be injected into the magnetic element in order to move the domain walls, temperature fluctuations in the magnetic element, in particular, an undesired heating of the magnetic element, affecting the performance of the magnetic device, can be reliably avoided. Also, no electrical contacts are necessary for the part of the operation of the device where a field is applied.

The magnetic device of the invention is configured so that no in-plane magnetic field, i.e., no magnetic field in a direction parallel to the plane of the magnetisation directions in the domains, is to be applied. Magnetic domain wall motion is controlled purely by the application of one or more magnetic field pulses to the at least a portion of the magnetic element in the direction perpendicular to the plane. The magnetic pulse application device is configured to apply magnetic field pulses to the at least a portion of the magnetic element in the direction perpendicular to the plane so as to move at least one domain wall or a plurality of domain walls along the length of the magnetic element. In particular, a plurality of domain walls can be synchronously moved along the length of the magnetic element.

Since the above precession and damping torques are directly proportional to the strength of the externally applied magnetic field, the distance over which the one or more magnetic domain walls travel until a new equilibrium state is reached, i.e., the domain wall displacement, increases with increasing applied magnetic field strength. Therefore, the domain wall displacement can be controlled by adjusting the amplitude of the applied magnetic field pulse or pulses.

Further, the domain wall displacement also depends on the damping constant, which is an intrinsic parameter of the magnetic material used for the magnetic element. Specifically, the domain wall displacement is roughly inversely proportional to the damping constant, since, for lower damping constants, it takes more time to find a new equilibrium state for the domain wall. Hence, the domain wall displacement can also be controlled by suitably choosing the magnetic material or materials for the magnetic element or, for example, by adjusting the damping constant of the magnetic element by heavy-ion doping, as is disclosed in the journal article "Magnetic-field-induced domain-wall motion in permalloy nanowires with modified Gilbert damping" by T. A. Moore et al. (Physical Review B 82, 094445 [2010]). The damping constant of the magnetic element may be chosen so as to be in a range of 1 x 10$^{-5}$ to 0.020, in a range of 1 x 10$^{-4}$ to 0.018, in a range of 0.001 to 0.016, in a range of 0.002 to 0.014, in a range of 0.004 to 0.012, in a range of 0.006 to 0.010 or in a range of 0.007 to 0.009.

Moreover, the above precession and damping torques can also be adjusted by appropriately setting the rise and/or fall times of the applied magnetic field pulse or pulses, thereby enabling a precise control of the domain wall displacement. The rise and fall times of each of the pulses may be substantially identical to each other or different from each other.

In particular, the magnetic pulse application device may be configured to apply asymmetric magnetic field pulses to the at least a portion of the magnetic element or the entire magnetic element, wherein, for each asymmetric magnetic field pulse, the rise time of the asymmetric magnetic field pulse is different from the fall time of the asymmetric magnetic field pulse. In this case, the rise time of the pulse and the fall time of the pulse can be independently adjusted, so as to allow for a particularly precise control of the domain wall displacement.

Further, the magnetic pulse application device may be configured to apply asymmetric magnetic field pulses to the at least a portion of the magnetic element or the entire magnetic element, wherein, for each asymmetric magnetic field pulse, a time profile of the asymmetric magnetic field pulse during the rise time is different from a time profile of the asymmetric magnetic field pulse during the fall time. In this case, the rise and fall times of the asymmetric magnetic field pulse may be identical to each other or different from each other. In particular, the time profiles of the rise and fall times may differ from each other by the number and/or width (i.e., duration or time length) and/or height (i.e., magnetic field strength) of the plateaus as defined above.

In one embodiment, the magnetic pulse application device is configured to apply asymmetric magnetic field pulses to the at least a portion of the magnetic element or the entire magnetic element, wherein, for each asymmetric field pulse, the fall time of the asymmetric magnetic field pulse is longer than the rise time of the asymmetric magnetic field pulse. Such an asymmetry of the magnetic field pulses is particularly advantageous for achieving a stable domain wall displacement, as will be detailed in the following.

In an ideal (i.e., theoretical) magnetic element, i.e., a perfect magnetic element without impurities, thickness variations or the like, a domain wall which has been moved by the application of a perpendicular external magnetic field will return to its initial position when the external field is switched off. Hence, for the application of magnetic field pulses, the displacement of the domain wall or walls is temporary, thus being suitable for a magnetic device of a volatile type.

For magnetic devices of a non-volatile type, a stable domain wall displacement, i.e., a domain wall displacement which is maintained, even after the external magnetic field has been switched off, is required. For achieving this purpose, one or more artificial domain wall pinning sites for pinning a magnetic domain wall can be provided in the magnetic element, as will be further detailed below. Moreover, magnetic elements generally have natural pinning sites, such as impurities, dimensional variations (e.g., thickness variations) and the like.

By using asymmetric magnetic field pulses in which the fall time is longer than the rise time, stable domain wall displacement can be achieved in an efficient and reliable manner. Specifically, by choosing a shorter rise time, i.e., a faster increase of the applied magnetic field and resulting torques, the domain wall can be quickly and reliably depinned and moved away from an initial artificial or natural pinning site, i.e., an artificial or natural pinning site by which the domain wall is pinned before the application of the magnetic field pulse.

Subsequently, the domain wall is moved along the length of the magnetic element by the applied perpendicular magnetic field during the dwell time or duration of the pulse. When the domain wall reaches a new artificial or natural pinning site, it is pinned by the pinning site by kinetic pinning, as is disclosed, for example, in the journal article "Detection of the static and kinetic pinning of domain walls in ferromagnetic nanowires" by S.-M. Ahn et al. (Applied Physics Letters 95, 152506 [2009]). When the domain wall is pinned at the artificial or natural pinning site, the domain wall starts a damped oscillatory motion that makes the wall eventually stop at this position. By choosing a longer fall time of the asymmetric magnetic field pulse, i.e., a slower decrease of the applied magnetic field, more time is provided for allowing this oscillation to dampen, so that the domain wall can be stably trapped at the artificial or natural pinning site and does not move back.

In one embodiment, the magnetic pulse application device is configured to apply asymmetric magnetic field pulses to the at least a portion of the magnetic element or the entire magnetic element, wherein, for each asymmetric magnetic field pulse, the fall time of the asymmetric magnetic field pulse is 1.5 times or more, preferably 1.8 times or more, more preferably 2.0 times or more, even more preferably 2.2 times or more and yet even more preferably 2.5 times or more, longer than the rise time of the asymmetric magnetic field pulse. In this way, a stable domain wall displacement can be achieved in a particularly efficient and reliable manner.

The rise time of each of the magnetic field pulses may be in the range of 100 ps to 1 ns, preferably in the range of 200 ps to 800 ps, more preferably in the range of 300 ps to 700 ps, even more preferably in the range of 400 ps to 600 ps and yet even more preferably in the range of 450 ps to 550 ps. In this way, it can be ensured that a domain wall which is pinned by a domain wall pinning site is reliably depinned, so as to enable efficient domain wall motion.

The fall time of each of the magnetic field pulses may be 200 ps or more, preferably 500 ps or more, more preferably 800 ps or more, even more preferably 1 ns or more, yet even more preferably 1.5 ns or more and yet still more preferably 2 ns or more. In this way, pinning of a domain wall to a new pinning site after domain wall motion is further facilitated, thereby allowing for a stable domain wall displacement to be achieved in a particularly reliable manner.

In one embodiment, a duration or dwell time of each of the magnetic field pulses is in the range of 0.1 ns to 20 ns, preferably in the range of 0.5 ns to 18 ns, more preferably in the range of 1 ns to 15 ns, even more preferably in the range of 2 ns to 12 ns, yet even more preferably in the range of 4 ns to 10 ns and yet still even more preferably in the range of 6 ns to 8 ns. By choosing a magnetic field pulse duration in this range, it can be ensured that the pulse duration is of the same order as the time scale for precession of the magnetisation around the applied field. Hence, domain wall motion can be achieved in a particularly efficient and reliable manner.

In particular, by using the intrinsic oscillating frequencies of the domain wall (which depend on the pinning site details), an optimum shape of the pulse (rise and fall times and shapes) can be engineered. Such intrinsic oscillating frequencies are detailed, for instance, in the journal articles "Resonant Amplification of Magnetic Domain-Wall Motion by a Train of Current Pulses" by L. Thomas et al. (Science 315, 1553 [2007]), "Oscillatory dependence of current-driven magnetic domain wall motion on current pulse length" by L. Thomas et al. (Nature 443, 197 [2006]) and "Detection of Current-Induced Resonance of Geometrically Confined Domain Walls" by D. Bedau et al. (Physical Review Letters 99, 146601 [2007]). The pulse duration may be chosen so that the Fourier transform thereof contains eigenfrequencies of the domain wall or multiples of these eigenfrequencies.

An amplitude of each of the magnetic field pulses may be in the range of 1 mT to 300 mT, preferably in the range of 10 mT to 250 mT, more preferably in the range of 50 mT to 220 mT, even more preferably in the range of 100 mT to 200 mT, yet even more preferably in the range of 120 mT to 180 mT and yet still even more preferably in the range of 140 mT to 160 mT. In this way, a sizable domain wall displacement along the length of the magnetic element can be achieved. The amplitude of each of the magnetic field pulses may be substantially constant across the width of the magnetic element.

The magnetic element may comprise at least one domain wall pinning site for pinning a magnetic domain wall. The at least one domain wall pinning site may be an artificial pinning site, i.e., a pinning site which is artificially created, or a natural pinning site, i.e., a pinning site which is initially present in the magnetic element. As has been detailed above, domain wall pinning sites enable the pinning of domain walls and thus a stable (or permanent) domain wall displacement. By creating at least one artificial domain wall pinning site in the magnetic element, the position in which a domain wall is to be pinned can be accurately set by appropriately positioning the artificial pinning site in the magnetic element.

The at least one domain wall pinning site may be formed by a geometrical variation of the magnetic element, such as a width and/or thickness variation of the magnetic element, and/or a variation of one or more of the magnetic properties of the magnetic element. The magnetic properties of the magnetic element may be locally varied, for example, by ion irradiation. In this way, the position of the at least one domain wall pinning site and thus the stable domain wall displacement can be accurately controlled.

The at least one domain wall pinning site may be formed by a pair of notches in the magnetic element, the notches being arranged on opposite sides of the magnetic element in the width direction of the magnetic element so as to be opposed to each other. The notches may have a rounded, rectangular, square, triangular or other polygonal cross-sectional shape.

In one embodiment, the magnetic element comprises a plurality of domain wall pinning sites for pinning magnetic domain walls, the domain wall pinning sites being spaced apart from each other. The domain wall pinning sites may be spaced apart from each other along the length of the magnetic element. The domain wall pinning sites may be artificial and/or natural domain wall pinning sites. By providing a plurality of domain wall pinning sites in this way, a plurality of stable states for a domain wall or domain walls are created, e.g., along the length of the magnetic element.

By applying a magnetic field pulse or magnetic field pulses to the magnetic element, a domain wall can be moved between these stable states or a plurality of domain walls can be synchronously moved between these stable states, thereby switching the magnetic device between different stable states. The domain wall pinning sites may be arranged so as to be spaced apart equidistantly from each other, e.g., along the length of the magnetic element.

The pulse rise time and/or the pulse duration and/or the pulse fall time and/or the pulse amplitude may be adjusted in accordance with the distance between adjacent pinning sites, i.e., so that the domain wall displacement induced by the pulse or pulses substantially coincides with this distance. In this way, stable domain wall displacement between different pinning sites can be achieved in a particularly reliable and efficient manner.

The magnetic element may be a nanoelement or a microelement, such as a nanowire or a microwire, a nanostrip or a microstrip or the like. The thickness of the magnetic element may be in the range of 1 to 30 nm, preferably in the range of 2 to 26 nm, more preferably in the range of 4 to 22 nm, even more preferably in the range of 6 to 20 nm, yet even more preferably in the range of 8 to 18 nm and yet still even more preferably in the range of 10 to 16 nm.

The width of the magnetic element may be in the range of 10 to 2,000 nm, preferably in the range of 50 to 1,800 nm, more preferably in the range of 100 to 1,600 nm, even more preferably in the range of 200 to 1,400 nm and yet even more preferably in the range of 400 to 1,200 nm. The length of the magnetic element may be in the range of 5 to 1,000 $\mu$m, preferably in the range of 10 to 800 $\mu$m, more preferably in the range of 20 to 600 $\mu$m and even more preferably in the range of 50 to 500 $\mu$m.

The width of the magnetic element may be larger than the thickness of the magnetic element. In particular, the width of the magnetic element may be 2 times or more, preferably 5 times or more, more preferably 10 times or more, even more preferably 20 times or more, and yet even more preferably 50 times or more, larger than the thickness of the magnetic element. The length of the magnetic element may be 5 times or more, preferably 10 times or more, more preferably 20 times or more, even more preferably 50 times or more and yet even more preferably 100 times or more, larger than the width of the magnetic element.

The magnetic element may be arranged so as to form any type of one-dimensional, two-dimensional or three-dimensional shape, in particular, for the case of an elongate magnetic element. For example, the magnetic element may be arranged in a straight (i.e., one-dimensional) manner, so that the length of the magnetic element forms a longitudinal axis of the magnetic element. Alternatively, the magnetic element may be arranged in a three-dimensional shape, such as a spiral shape or the like.

In one embodiment, the magnetic element forms a closed loop or an interconnected mesh with multiple interconnections, such as a circle, an ellipse, a rectangle, a square, a triangle or any other polygonal shape, an array of these or arrays of single or interconnected of these. In this case, the length of the magnetic element may form the circumference of the closed loop. By forming the magnetic element as a closed loop, domain walls can be moved continuously along the length of the magnetic element.

The magnetic device may further comprise at least one magnetic field sensor for detecting the magnetisation, e.g., the magnetisation direction, in at least a portion of the magnetic element. The at least one magnetic field sensor may be configured to detect the magnetisation, e.g., the magnetisation direction, in at least one magnetic domain and/or at least one magnetic domain wall. The at least one magnetic field sensor may be, for example, a giant magnetoresistance (GMR) sensor, a tunnel magnetoresistance (TMR) sensor or a Hall effect sensor.

In one embodiment, the at least one magnetic field sensor may be arranged in a stationary manner. In this case, domain wall motion in the magnetic element can be induced by applying perpendicular magnetic field pulses to the magnetic element using the magnetic pulse application device, thereby moving the domain wall or walls and thus also the magnetic domains past the stationary magnetic field sensor. By applying a suitable pulse or sequence of pulses, a desired magnetic domain or domain wall can be moved to a sensing area of the sensor and the magnetisation, e.g., the magnetisation direction, in the domain wall or domain can be detected by the magnetic field sensor. In this way, magnetic information stored in the domain wall or the domain, e.g., as magnetisation direction up or down, can be read by the sensor.

Alternatively, the at least one magnetic field sensor may be arranged in a movable manner, so as to be movable to different portions of the magnetic element. In this case, the magnetic field sensor can be moved to the position of a particular domain or domain wall and used to detect the magnetisation, e.g., the magnetisation direction, in this domain or domain wall.

Further, a plurality of magnetic field sensors may be arranged at different positions of the magnetic element. For example, the magnetic field sensors may be disposed along the length of the magnetic element. In this way, the magnetisations, e.g., the magnetisation directions, in a plurality of magnetic domains and/or domain walls can be detected simultaneously.

In one embodiment, the magnetic device further comprises a magnetisation switching device for switching the magnetisation direction in one or more of the magnetic domains. The magnetic switching device may be any type of device capable of applying a magnetic field. For example, the magnetisation switching device may comprise a conductive element, such as a conductive wire, strip, bar or the like, through which a current can be passed so as to generate a magnetic field.

The magnetisation switching device may be configured to apply a magnetic field in the plane of the magnetisation directions of the magnetic domains. By applying such a field to a selected magnetic domain, the magnetisation direction in this domain can be switched, thereby writing magnetic information, e.g., as magnetisation direction up or down, into the domain. By switching, i.e., changing, the magnetisation directions in adjacent magnetic domains, the magnetisation direction in the domain wall separating these domains can be changed. In this way, the magnetisation switching device can also be used for switching the magnetisation direction in a domain wall, thus writing magnetic information into the domain wall.

The magnetisation switching device may be configured to inject a spin-polarised current into the magnetic element, in order to locally reverse the magnetisation in a selected domain by the spin torque effect, thereby writing information into the domain.

By appropriately switching the magnetisation directions in the magnetic domains using the magnetisation switching device, desired spin structures can be created in the domain wall or walls separating the domains. In particular, the magnetisation directions in the magnetic domains may be switched so that adjacent or neighbouring domain walls have opposite spin structures to each other, e.g., spin structures with opposite rotation directions of the magnetisations in the domain walls to each other, as has been detailed above.

The magnetisation switching device may be arranged in a stationary manner. In this case, the magnetic pulse application device may be used to move the domain wall or walls and thus also the magnetic domains past an active area of the magnetisation switching device. Thus, a selected magnetic domain can be moved to the active area of the magnetisation switching device and the magnetisation of this magnetic domain can be switched by a magnetic field applied by the magnetisation switching device. In this way, magnetic information can be written into the magnetic element.

Alternatively, the magnetisation switching device may be arranged so as to be movable along the length of the magnetic element. In this case, the magnetisation switching device may be moved to a selected magnetic domain and be used to switch the magnetisation direction thereof. Further, a plurality of magnetisation switching devices may be disposed along the length of the magnetic element. In this case, the magnetisation directions in a plurality of magnetic domains can be switched simultaneously.

In particular, if no domain structure is initially, i.e., before operation of the magnetic device, present in the magnetic element, the magnetisation switching device can be used to form a plurality of magnetic domains along the length of the magnetic element, wherein adjacent magnetic domains are separated from each other by a magnetic domain wall.

According to the second aspect, the present invention provides a method of operating the magnetic device of the invention. The method comprises the step of applying one or more magnetic field pulses to the at least a portion of the magnetic element or the entire magnetic element in the direction perpendicular to the plane.

The method according to the invention provides the advantageous effects already described in detail above for the magnetic device of the invention. In particular, the method enables a controlled and reliable domain wall motion in the magnetic element.

In one embodiment, the method may further comprise the steps of forming a plurality of magnetic domains in the magnetic element, so that the magnetic domains are arranged adjacent to each other, e.g., along the length of the magnetic element, the magnetisations of the magnetic domains are oriented so that the magnetisation directions are aligned parallel to the plane, the magnetisations of adjacent magnetic domains are oriented in different directions from each other, preferably in opposite directions to each other, and adjacent magnetic domains are separated from each other by a magnetic domain wall.

In the step of applying one or more magnetic field pulses to the at least a portion of the magnetic element, asymmetric magnetic field pulses may be applied to the at least a portion of the magnetic element, wherein, for each asymmetric magnetic field pulse, the rise time of the asymmetric magnetic field pulse is different from the fall time of the asymmetric magnetic field pulse.

The fall time of the asymmetric magnetic field pulse may be longer than the rise time of the asymmetric magnetic field pulse. In particular, the fall time of the asymmetric magnetic field pulse may be 1.5 times or more, preferably 1.8 times or more, more preferably 2.0 times or more, even more preferably 2.2 times or more and yet even more preferably 2.5 times or more, longer than the rise time of the asymmetric magnetic field pulse.

The rise time of each of the magnetic field pulses may be in the range of 100 ps to 1 ns, preferably in the range of 200 ps to 800 ps, more preferably in the range of 300 ps to 700 ps, even more preferably in the range of 400 ps to 600 ps and yet even more preferably in the range of 450 ps to 550 ps.

The duration of each of the magnetic field pulses may be in the range of 0.1 ns to 20 ns, preferably in the range of 0.5 ns to 18 ns, more preferably in the range of 1 ns to 15 ns, even more preferably in the range of 2 ns to 12 ns, yet even more preferably in the range of 4 ns to 10 ns and yet still even more preferably in the range of 6 ns to 8 ns.

The amplitude of each of the magnetic field pulses may be in the range of 1 mT to 300 mT, preferably in the range of 10 mT to 250 mT, more preferably in the range of 50 mT to 220 mT, even more preferably in the range of 100 mT to 200 mT, yet even more preferably in the range of 120 mT to 180 mT and yet still even more preferably in the range of 140 mT to 160 mT. The method may further comprise the step of detecting the magnetisation, e.g., the magnetisation direction, in at least a portion of the magnetic element. The magnetisation in the at least a portion of the magnetic element may be detected by using at least one magnetic field sensor, as has been detailed above.

The method may further comprise the step of switching the magnetisation direction in one or more of the magnetic domains. The magnetisation direction in one or more of the magnetic domains may be switched by using a magnetisation switching device, as has been detailed above.

The method of the invention is a method of operating the magnetic device of the invention. Hence, the further features disclosed in connection with the above description of the magnetic device of the invention may also be applied to the method of the invention.

Brief Description of the Drawings

Hereinafter, non-limiting examples are explained with reference to the drawings, in which:

Fig. 1        shows a schematic view of a magnetic device according to an embodiment of the present invention, wherein Fig. 1 (a) shows a perspective view of a portion of the magnetic device and Fig. 1(b) shows a top view of a portion of the magnetic device;

Fig. 2        shows a schematic view illustrating the operation of the magnetic device shown in Fig. 1;

Fig. 3        shows an illustration of an applied field geometry and a resulting domain wall motion, wherein Fig. 3(a) shows a magnetic field distribution during the application of a perpendicular pulse and Figs. 3(b) and (c) illustrate domain wall motion for two different types of domain walls;

Fig. 4        shows diagrams of the domain wall displacement as a function of time for different pulse amplitudes (Fig. 4(a)) and damping constants (Fig. 4(b));

Fig. 5        shows illustrations of domain wall motion and domain wall pinning, wherein Fig. 5(a) is a diagram showing the domain wall displacement as a function of time for an asymmetric applied field pulse and Fig. 5(b) illustrates the domain wall motion and subsequent domain wall pinning;

Fig. 6        shows diagrams of the domain wall displacement as a function of time for different field amplitudes (Fig. 6(a)) and different magnetic element thicknesses (Fig. 6(b));

Fig. 7        shows diagrams of the domain wall displacement as a function of time for different damping constants (Fig. 7(a)) and different types of domain walls (Fig. 7(b));

Fig. 8        shows an illustration of the synchronous motion of multiple domain walls, wherein Fig. 8(a) shows an initial state of the domain walls, Fig. 8(b) shows a state of the domain walls after the application of a positive field pulse perpendicular to the plane of the magnetic element and Fig. 8(c) shows a state of the domain walls after the application of a negative field pulse perpendicular to the plane of the magnetic element;

Fig. 9        shows diagrams of the domain wall displacement as a function of time for different pulse rise times (Fig. 9(a)) and different pulse fall times (Fig. 9(b)); and

Fig. 10      shows illustrations of multiple domain wall motion by the application of magnetic field pulses for the case of two domain walls (Fig. 10(a)) and three domain walls (Fig. 10(b)).

Detailed Description of Preferred Embodiments

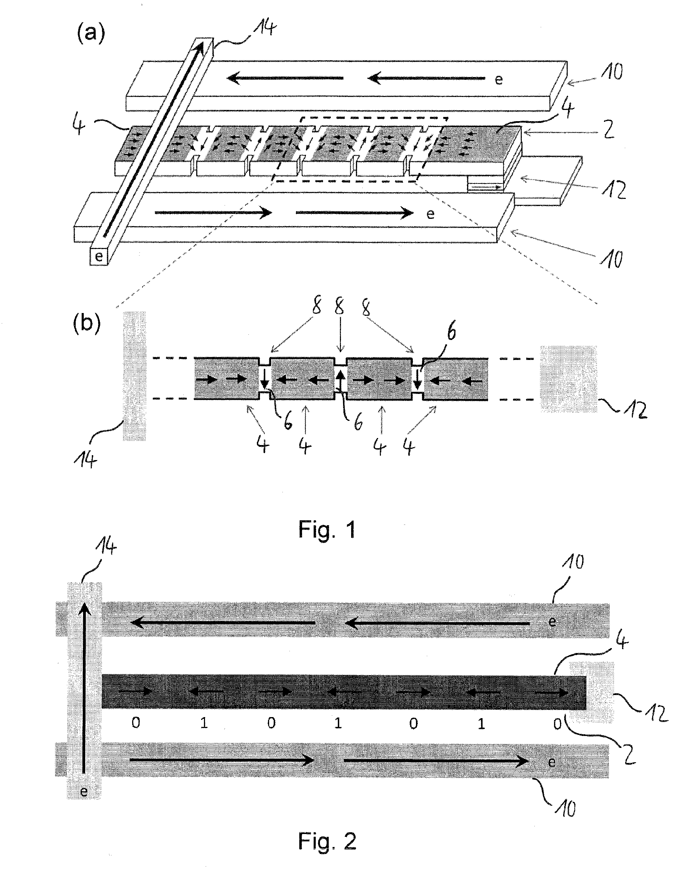

Fig. 1 shows a schematic view of a portion of the magnetic device according to a preferred embodiment of the present invention. Fig. 1(b) shows a schematic top view of the portion of the magnetic device shown in Fig. 1(a) which is indicated by a dashed rectangle in Fig. 1(a).

The magnetic device shown in Fig. 1 comprises an elongate magnetic element 2 and a magnetic pulse application device 10. The magnetic element 2 is made of a ferromagnetic material, such as Fe, Ni, Co, NiFe, CoFe or the like, and formed as a strip or wire. The magnetic element 2 has a length in the range of 1 to 20 $\mu$m, a width in the range of 50 to 200 nm and a thickness in the range of 5 to 20 nm. A plurality of magnetic domains 4 are present in the magnetic element 2 and arranged adjacent to each along the length of the magnetic element 2. The magnetisations of the magnetic domains 4 are oriented so that the magnetisation directions are aligned parallel to a plane perpendicular to the thickness direction of the magnetic element 2, i.e., the magnetic element 2 is magnetised in-plane.

As is schematically shown in Fig. 1(b), the magnetisations of adjacent magnetic domains 4 are oriented in opposite directions to each other along the longitudinal axis of the magnetic element 2. Adjacent magnetic domains 2 are separated from each other by transverse magnetic domain walls 6. The magnetisation directions in the magnetic domain walls 6 alternate along the length of the magnetic element 2 (Fig. 1(b)). Thus, neighbouring/adjacent domain walls 6 have their magnetisations point in opposite directions.

In Figs. 1(a) and (b), only a portion of the magnetic element 2 is shown for better presentability. The magnetic element 2 extends further beyond the longitudinal ends of the magnetic pulse application device 10, i.e., to the right and to the left in Figs. 1(a) and (b), in a continuous manner. The magnetic domain and domain wall structures of these further portions of the magnetic element 2 are substantially the same as those shown in Figs. 1(a) and (b) and detailed above.

The magnetic element 2 comprises a plurality of artificial domain wall pinning sites in the form of pairs of notches 8 in the magnetic element 2, the notches 8 being arranged on opposite sides of the magnetic element 2 in the width direction of the magnetic element 2 so as to be opposed to each other. The pairs of notches 8 are equidistantly spaced apart from each other along the length of the magnetic element 2. As is schematically shown in Figs. 1(a) and (b), the domain walls 6 are pinned by the pairs of notches 8 and thus stably held in their positions along the length of the magnetic element 2 when no external magnetic field is applied.

The magnetic pulse application device 10 is formed by a pair of parallel magnetic strip lines arranged on opposite sides of the magnetic element 2 and extending along the length direction of the magnetic element 2, as is schematically shown in Fig. 1(a). By passing electrical current pulses e through the magnetic strip lines in opposite directions, as is indicated by the arrows in Fig. 1(a), a magnetic field pulse is applied to the magnetic element 2 in a direction perpendicular to the plane of the magnetisation directions, i.e., in the out-of-plane direction parallel to the thickness direction of the magnetic element 2.

By applying such a magnetic field pulse or a sequence of such magnetic field pulses, the magnetic domain walls 6 can be moved along the length of the magnetic element 2. In particular, the domain walls 6 can be synchronously moved between different pairs of notches 8, thereby switching the magnetic device.

The magnetic device 2 further comprises a magnetic field sensor 12 in the form of a GMR or TMR sensor, which is disposed in a stationary manner adjacent to the magnetic element 2 and configured to detect the magnetisation direction of the magnetic domain 4 arranged next to the sensor 12, i.e., the magnetic domain 4 on the right-hand side of the magnetic element 2 in Fig. 1(a). The magnetic field sensor 12 may be, for example, arranged adjacent to an end or the centre of the magnetic element 2 in the longitudinal direction thereof.

The magnetic pulse application device 10, e.g., the strip lines thereof, may extend to one end or both ends of the magnetic element 2, i.e., along the entire length of the magnetic element 2, in the longitudinal direction thereof. In particular, if the magnetic field sensor 12 is arranged adjacent to an end of the magnetic element 2 in the longitudinal direction thereof, the magnetic pulse application device 10, e.g., the strip lines thereof, may extend to this end of the magnetic element 2.

By applying appropriate magnetic field pulses to the magnetic element 2 using the magnetic pulse application device 10, the magnetic domain walls 6 and thus also the magnetic domains 4 can be moved along the length of the magnetic element 2, as has been detailed above. In this way, a selected magnetic domain 4 or domain wall 6 can be moved to the position of the magnetic element 2 where the magnetic field sensor 12 is located and the magnetisation direction in the magnetic domain 4 or domain wall 6 can be detected by the sensor 12. Thus, magnetic information stored in the magnetic element 2 can be read out in a simple and reliable manner.

Further, the magnetic device comprises a magnetisation switching device 14 comprising a conductive element, such as a conductive wire, strip, bar or the like, as is schematically shown in Fig. 1(a), which is arranged in a direction perpendicular to the length of the magnetic element 2 and the magnetic strip lines of the magnetic pulse application device 10. The magnetisation switching device 14 is arranged adjacent to the magnetic element 2 and configured to switch the magnetisation direction in the magnetic domain 4 of the magnetic element 2 arranged next to the magnetisation switching device 14.

By applying a magnetic field pulse or a sequence of magnetic field pulses to the magnetic element 2 using the magnetic pulse application device 10, as has been detailed above, the domain walls 6 and thus also the magnetic domains 4 can be moved along the length of the magnetic element 2. In this way, a selected magnetic domain 4 can be positioned adjacent to the conductive element of the magnetisation switching device 14 and the magnetisation direction of this domain 4 can be switched, i.e., changed, by the magnetisation switching device 14. Thus, magnetic information, i.e., magnetisation direction to the left or to the right in Fig. 1, can be written into each magnetic domain 4 of the magnetic element 2 in a simple and reliable manner.

Fig. 2 schematically shows an operation of the magnetic device of Fig. 1, in which the device is used for recording and storing data. In particular, the magnetisation direction in the magnetic domains 4 is employed as the information carrier, wherein a magnetisation direction to the right in Fig. 2 represents a 0 and a magnetisation direction to the left in Fig. 2 represents a 1. In this way, information can be recorded and stored in the magnetic element 2 by using the magnetic domains as bits.

The information can be written by using the magnetisation switching device 14 in combination with the magnetic pulse application device 10 and read by using the magnetic field sensor 12 in combination with the magnetic pulse application device 10, as has been explained in detail above.

Further, the domain walls 6 may be used as magnetic bits, wherein, for example, an upward magnetisation direction in the domain wall 6 in Fig. 1(b) may represent a 0 and a downward magnetisation direction in the domain wall 6 in Fig. 1 (b) may represent a 1. Since the magnetic device allows for a synchronous motion of multiple domain walls 6 along the length of the magnetic element 2, information can be recorded in the magnetic element 2 and read out from the magnetic element 2 in a simple, quick and reliable manner.

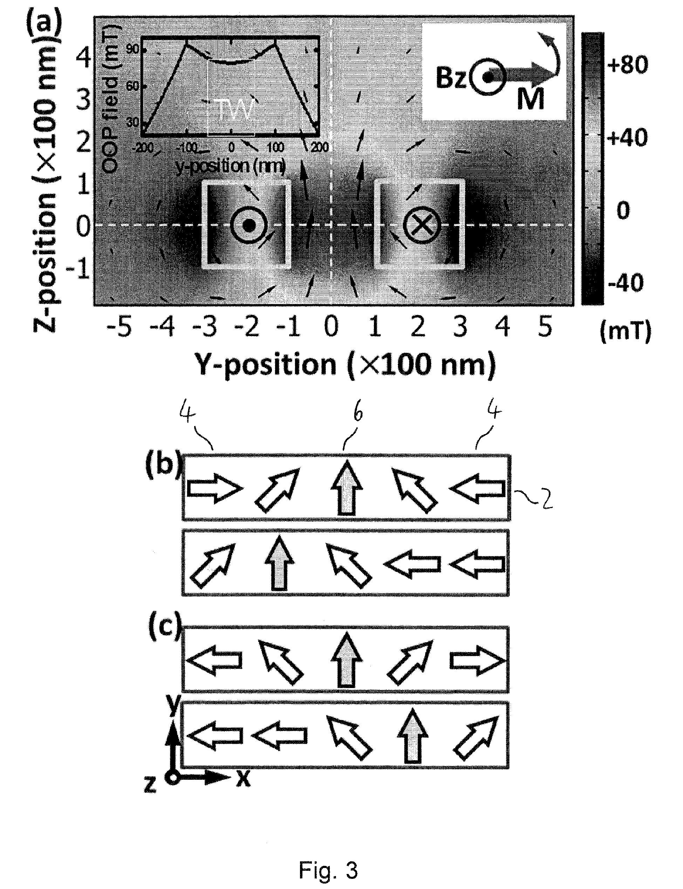

Fig. 3(a) shows a numerically calculated, two-dimensional field distribution of a magnetic field applied in the direction (z-direction) perpendicular to the plane of the magnetisation directions of the magnetic domains 4, i.e., the thickness direction of the magnetic element 2. In particular, Fig. 3(a) shows the magnetic field strength as a function of the z-position, i.e., the position along the thickness direction of the magnetic element 2, and the y-position, i.e., the position along the widthwise direction of the magnetic element 2 (y-direction).

The two light grey squares in Fig. 3(a) indicate the magnetic strip lines of the magnetic pulse application device 10 viewed in the direction of the longitudinal axes of the strip lines. In the numerical calculations, the current was passed through the magnetic strip line on the right-hand side of Fig. 3(a) in a direction perpendicular to the plane of the drawing and into the plane of the drawing and the current was passed through the magnetic strip line on the left-hand side of Fig. 3(a) in a direction perpendicular to the plane of the drawing and out of the plane of the drawing. The applied current density was $1 \times 10^{12}$ A/m$^2$ and the applied current was 40 mA.

Further, in the numerical calculations, Au was taken as the material of the magnetic strip lines and the magnetic strip lines were set to have a cross-section in a plane perpendicular to the longitudinal axes thereof of 200 nm x 200 nm. The magnetic element 2 is arranged between the two magnetic strip lines and extends in a direction parallel thereto, as is schematically shown in Figs. 1 and 2. The inset on the left-hand side of Fig. 3(a) shows the strength of the applied perpendicular magnetic field, i.e., the out-of-plane field (OOP field), as a function of the y-position, i.e., the position along the width of the magnetic element 2. As can be seen from this inset, the magnetic field varies only slightly along the $\gamma$-direction, i.e., from 78 mT to 82 mT for y = - 50 nm to y = +50 nm.

The inset on the right-hand side of Fig. 3(a) illustrates the precession of the magnetisation if a perpendicular magnetic field is applied. Specifically, if a magnetic field Bz is applied in the positive z-direction, perpendicular to the plane of the magnetisation directions (out of the plane of the drawing in the inset of Fig. 3(a)), a counterclockwise precession of the magnetisation M around the direction of the applied magnetic field Bz is induced.

A transverse magnetic domain wall 6 in the magnetic element 2 has a degree of freedom, namely the chirality. Specifically, a transverse magnetic domain wall 6 has a positive chirality (chirality up) if the magnetisation in the domain wall 6 points in the positive y-direction and a negative chirality (chirality down) if the magnetisation in the domain wall 6 points in the negative y-direction. For example, in the portion of the magnetic device shown in Fig. 1(b), a sequence of transverse magnetic domain walls 6 with negative chirality, positive chirality and negative chirality is schematically shown. Due to the symmetry breaking by the chirality, the directions of the transverse domain wall motion are opposite to each other for opposite chiralities.

Moreover, two types of transverse magnetic domain walls 6 exist, namely so-called "head-to-head" domain walls and so-called "tail-to-tail" domain walls. In a head-to-head transverse domain wall 6, the magnetisation directions of the two adjacent magnetic domains 4 which are separated by the domain wall 6 point towards the magnetic domain wall 6, as is schematically shown in Fig. 3(b). In a tail-to-tail transverse domain wall 6, the magnetisation directions in two adjacent magnetic domains 4 which are separated by the domain wall 6 point away from the domain wall 6, as is schematically shown in Fig. 3(c).

The direction of the domain wall motion also depends on the type of the transverse domain wall 6. As is schematically shown in Figs. 3(b) and (c), head-to-head (Fig. 3(b)) and tail-to-tail (Fig. 3(c)) domain walls 6 having the same chirality move into opposite directions upon the application of a perpendicular magnetic field.

Head-to-head transverse domain walls 6 with positive chirality and tail-to-tail transverse domain walls 6 with negative chirality move along the negative x-direction in Figs. 3(b) and (c) and head-to-head transverse domain walls 6 with negative chirality and tail-to-tail transverse domain walls 6 with positive chirality move along the positive x-direction in Figs. 3(b) and (c). Hence, since the magnetic domain walls 6 schematically shown in Fig. 1(a) are head-to-head transverse domain walls 6 with negative chirality and tail-to-tail transverse domain walls 6 with positive chirality, the domain walls 6 will synchronously move into the same direction when a perpendicular magnetic field pulse is applied.

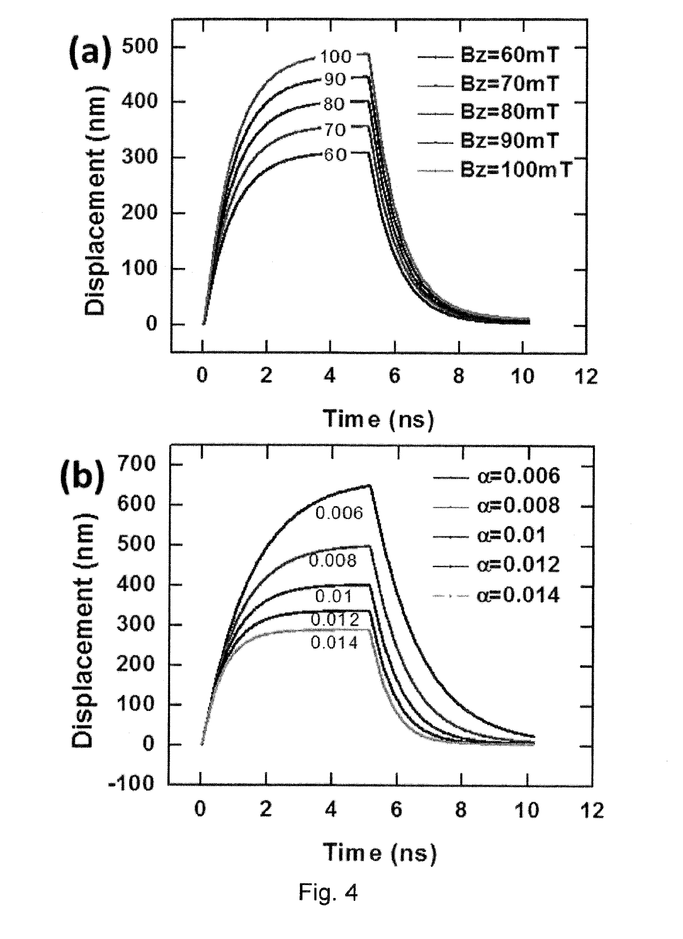

Figs. 4 to 10 show micromagnetic simulations which were performed using the object oriented micromagnetic framework (OOMMF; http://math.nist.org/oommf) code for solving the Landau-Lifshitz equation. For these micromagnetic simulations, a simulation cell size of $5 \times 5 \times 10$ nm$^3$ below the exchange length was chosen and standard material parameters for permalloy ($Ni_{80}Fe_{20}$) were used. Further, a saturation magnetisation Ms of $800 \times 10^5$ A/m, an exchange stiffness A = $1.3 \times 10^{-11}$ J/m and a damping constant $\alpha = 0.006 - 0.014$ were used in the simulations. For the magnetic element 2, a length of 10 $\mu$m, a width of 50 or 100 nm and a thickness of 10 nm were set.

Since the precession and damping torques generated by the applied magnetic field pulse are directly proportional to the magnetic field strength, i.e., the amplitude of the pulse, an increase of the domain wall displacement is observed for increasing field strength. Fig. 4(a) shows micromagnetic simulation results for a head-to-head transverse domain wall 6 with negative chirality placed at the center of the magnetic element 2 and a perpendicular symmetric magnetic field pulse with rise and fall times of 100 ps and a pulse duration of 5 ns applied along the positive z-direction. The damping constant was fixed to 0.01 and the width of the magnetic element 2 was set to 100 nm.

As can be seen from Fig. 4(a), the domain wall displacement increases with increasing pulse amplitude Bz. For a pulse amplitude of 100 mT, which corresponds to a current of 50 mA in the magnetic strip lines, a domain wall displacement of up to 486 nm is observed. As can be further taken from Fig. 4(a), the domain wall 6 moves back to its initial position, i.e., to a displacement of zero, after the perpendicular magnetic field is switched off.

Fig. 4(b) shows micromagnetic simulation results for a domain wall and pulse configuration as specified above for Fig. 4(a) and a magnetic field pulse amplitude of 80 mT and varying damping constants $\alpha$ of 0.006 to 0.014. The damping constant of a system can be tuned, for example, by rare-earth and/or heavy-ion doping, as has been explained above.

As is shown in Fig. 4(b), the domain wall displacement is inversely proportional to the damping constant, since it takes longer to find a new equilibrium state for a domain wall for lower damping. For a damping constant of 0.006, a domain wall displacement of up to approximately 650 nm was observed.

In order to simulate the presence of an artificial or natural pinning site in the magnetic element 2, a square notch 8 (5 nm x 5 nm) in the magnetic element 2 at a position 400 nm away from the center of the element 2 was included in the micromagnetic simulations, since the maximum domain wall displacement with a pulse amplitude of 80 mT and a damping constant of 0.01 was found to be approximately 400 nm. The damping constant was fixed to 0.01 and the width of the magnetic element 2 was set to 100 nm. Further, an asymmetric magnetic field pulse, i.e., a magnetic field pulse in which the rise time of the pulse is different from the fall time of the pulse, was applied, in order to adjust the precession and damping torques.

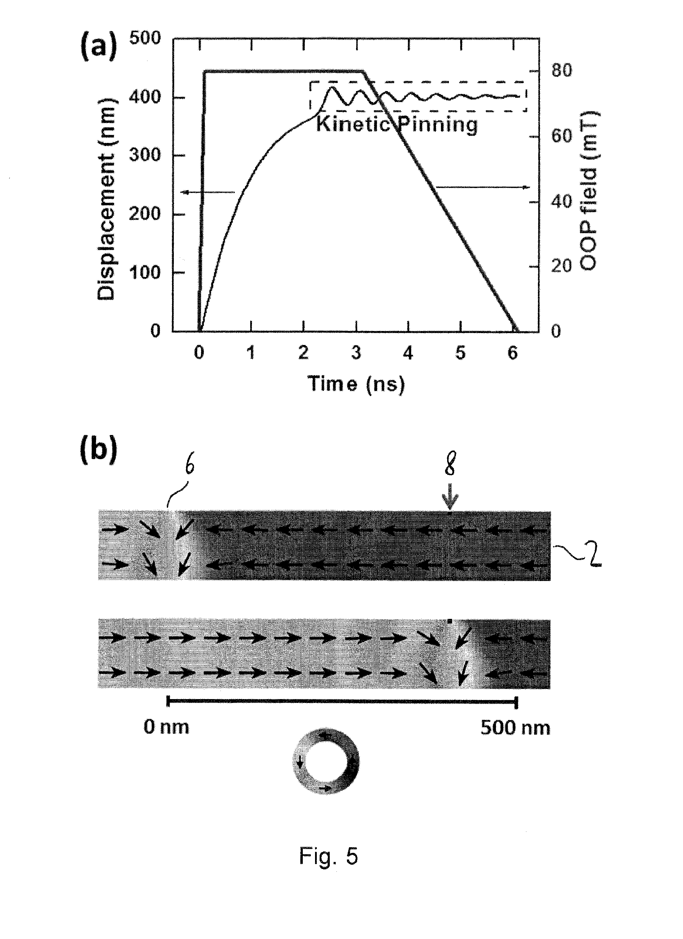

Fig. 5 (a) shows the micromagnetic simulation results for an asymmetric field pulse with a rise time of 100 ps, a pulse duration of 3 ns and a fall time of 3 ns and a head-to-head transverse domain wall 6 with negative chirality. As is shown in Fig. 5(a), such a domain wall 6 moves along the length of the magnetic element 2 and is kinetically pinned at the notch 8. When the domain wall 6 is pinned at the notch 8, the domain wall 6 starts a damped oscillatory motion. After a simulation time of 3.1 ns, i.e., after the rise time and the duration of the pulse, the applied perpendicular magnetic field decreased for a fall time of 3 ns, allowing for the oscillation of the domain wall 6 at the notch 8 to sufficiently dampen and thereby permanently trapping the domain wall 6 at the notch 8. Hence, these results demonstrate that a stable domain wall motion can be achieved in a simple and reliable manner by the magnetic device and the method according to the invention.

Fig. 5(b) shows micromagnetic simulation results of the magnetisation distribution in the magnetic element 2 in the initial state (upper part of Fig. 5(b)) and the final state (lower part of Fig. 5(b)) of the simulation of Fig. 5(a), wherein, in the final state, the domain wall 6 is pinned by the notch 8. The grey scale circle indicates the magnetisation direction in the magnetic element 2. The vertical direction in Fig. 5(b) is the y-direction, i.e., the widthwise direction, of the magnetic element 2.

As can be seen from Fig. 5(b), the domain wall 6 is moved along the length of the magnetic element 2 by approximately 400 nm by the application of the asymmetric magnetic field pulse shown in Fig. 5(a) and subsequently pinned by the notch 8. The average domain wall velocity of this motion is approximately 65 m/s.

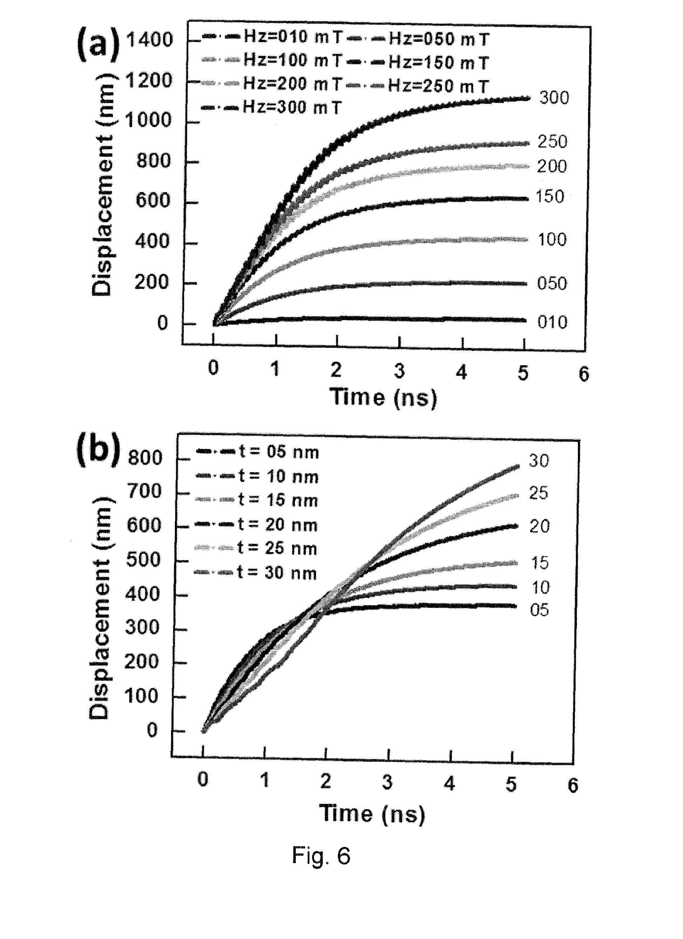

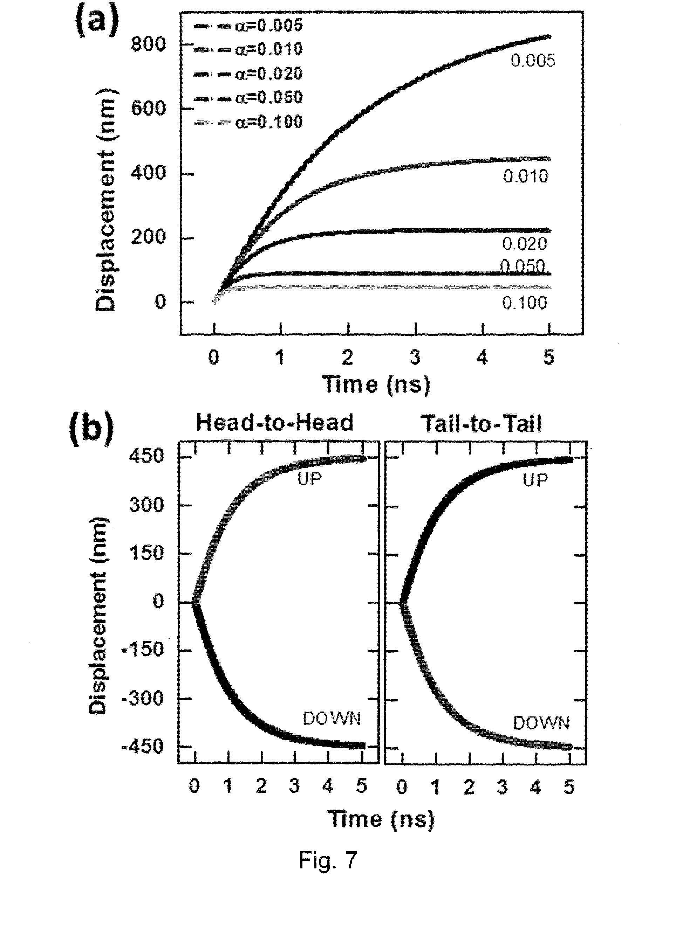

Further micromagnetic simulation results are shown in Figs. 6 and 7, illustrating the dependence of the domain wall displacement on magnetic field strength Hz (Fig. 6(a)), thickness t of the magnetic element 2 (Fig. 6(b)), damping constant $\alpha$ (Fig. 7(a)) and chirality and type of domain wall (Fig. 7(b)). In order to demonstrate the effect of the displacement, in these simulations, a constant magnetic field rather than a magnetic field pulse was applied.

For an applied magnetic field of 300 mT, high domain wall velocities of up to approximately 560 m/s without a Walker breakdown were observed (Fig. 6(a)).

The thickness dependent domain wall displacements presented in Fig. 6(b) show that the demagnetisation field in the y-direction, i.e., along the widthwise direction of the magnetic element 2, is not negligible and that the domain wall displacement is influenced not only by the demagnetisation field in the z-direction but also by the demagnetisation field in the y-direction.

The damping constant dependent domain wall displacements shown in Fig. 7(a) add further support to the above observation that larger domain wall displacements are observed for smaller damping constants.

Moreover, Fig. 7(b) further illustrates the explanations concerning domain wall motion for different chiralities and types of domain walls 6 presented above, showing that head-to-head domain walls 6 with positive chirality and tail-to-tail domain walls 6 with negative chirality move along the negative x-direction and head-to-head domain walls 6 with negative chirality and tail-to-tail domain walls 6 with positive chirality move along the positive x-direction. For these simulations, the width of the magnetic element 2 was set to 50 nm. The magnetic damping constant was fixed to 0.01 and the amplitude of the magnetic field was 100 mT.

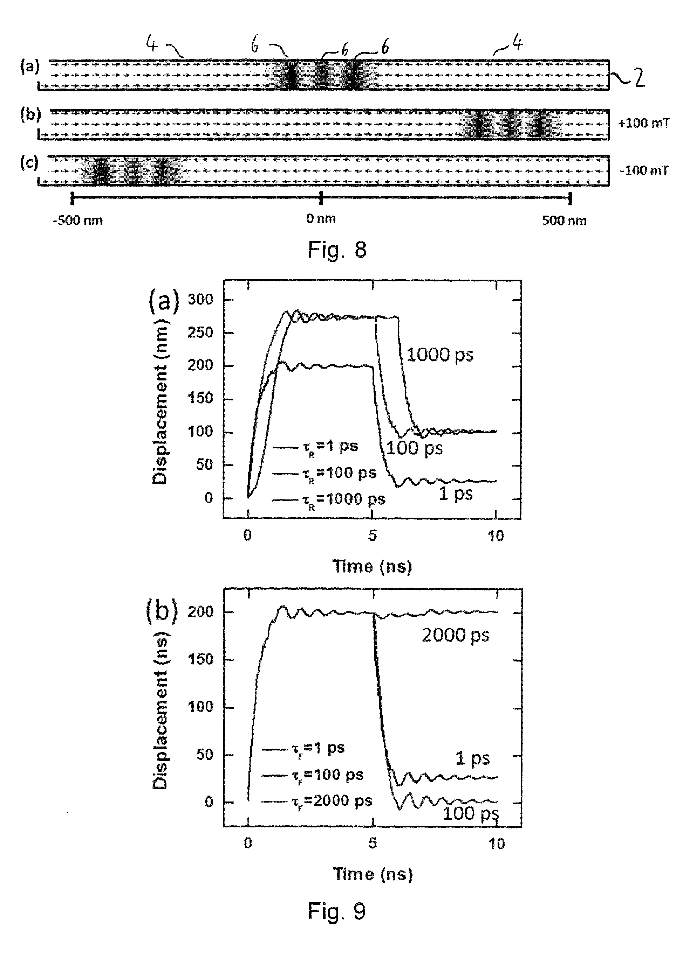

Fig. 8 shows micromagnetic simulation results for the magnetisation distribution in the magnetic element 2 for the case of three domain walls 6 before the application of a perpendicular magnetic field (Fig. 8(a)), after the application of a positive perpendicular magnetic field with a strength of +100 mT (Fig. 8(b)) and after the application of a negative perpendicular magnetic field with a strength of -100 mT (Fig. 8(c)). The vertical direction in Figs. 8(a) to (c) is the y-direction, i.e., the widthwise direction, of the magnetic element 2. In these simulations, a constant magnetic field rather than a magnetic field pulse was applied. The width of the magnetic element 2 was set to 50 nm. The magnetic damping constant was fixed to 0.01 and the amplitude of the magnetic field was 100 mT.

As can be seen from Fig. 8, a synchronous displacement of the three domain walls 6 by approximately 300 nm in opposite directions for positive and negative fields is observed. The three domain walls 6 move synchronously without any annihilation of adjacent domain walls 6 in contrast to the conventional approach of applying in-plane magnetic fields.

Fig. 9 shows micromagnetic simulation results for a magnetic element 2 with regularly spaced pinning sites, i.e., notches 8, for pinning domain walls 6: Specifically, square notches 8 (5 nm x 5 nm) were introduced in a widthwise side of the magnetic element 2 as defined above (having a width of 100 nm), with a distance between two adjacent notches 8 of 20 nm. A head-to-head domain wall 6 with negative chirality was nucleated at the center of the magnetic element 2. Subsequently, asymmetric field pulses with different rise times $\tau_R$ and fall times $\tau_F$ were simulated. The magnetic damping constant was fixed to 0.01.

As is shown in Fig. 9(a), a maximum domain wall displacement was observed for rise times $\tau_R$ of the pulse of 100 ps to 1 ns. Due to the asymmetry of the pulse, the domain wall 6 could be stably pinned at one of the notches 8. For the simulations shown in Fig. 9(a), the fall time $\tau_F$ was fixed at 1 ps.

For the simulation results shown in Fig. 9(b), the rise time $\tau_R$ was fixed at 1 ps and the fall time $\tau_F$ was varied from 1 ps to 2000 ps. As is shown in Fig. 9(b), a maximum domain wall displacement was observed for a fall time $\tau_F$ of the pulse of 2 ns. For this fall time, the domain wall 6 stayed pinned and did not move back towards its initial position.

These simulation results clearly demonstrate that the domain wall displacement can be adjusted by suitably setting the rise and fall times of the applied perpendicular magnetic field pulse or pulses.

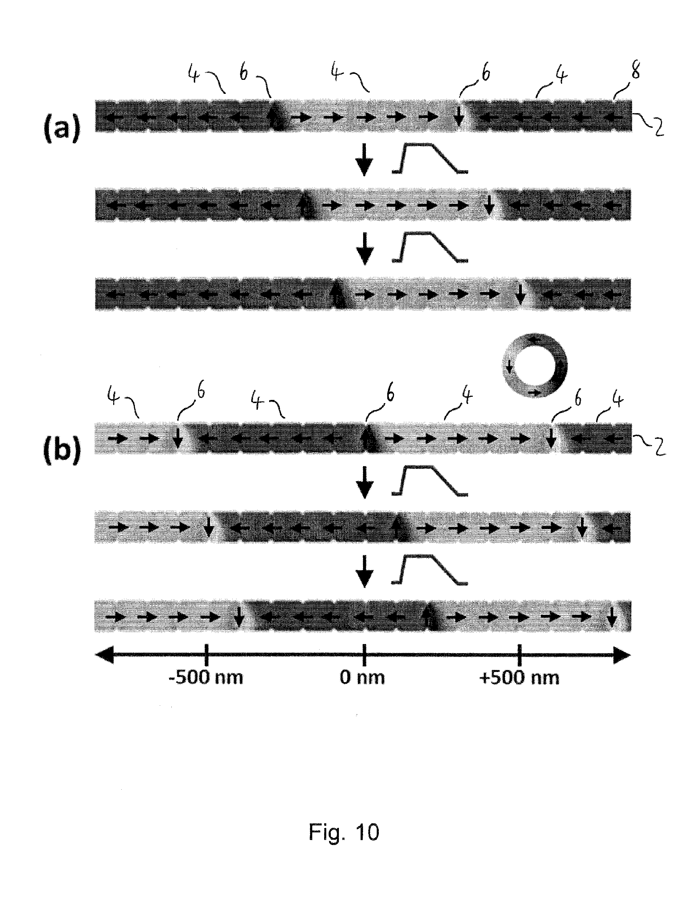

Fig. 10 shows micromagnetic simulation results of the magnetisation distribution in the magnetic element 2 for the case of two (Fig. 10(a)) and three (Fig. 10(b)) transverse magnetic domain walls 6. The vertical direction in Figs. 10(a) and (b) is the y-direction, i.e., the widthwise direction, of the magnetic element 2. The grey scale circle indicates the magnetisation direction in the magnetic element 2. The width of the magnetic element 2 was set to 50 nm. The magnetic damping constant was fixed to 0.01 and the amplitude of the magnetic field was 100 mT.

The magnetic element 2 is provided with a plurality of pairs of triangular notches 8 (with a base line of 15 nm and a height of 10 nm), the notches 8 being arranged on opposite sides of the magnetic element 2 in the width direction thereof so as to be opposed to each other. The pairs of notches 8 are equidistantly spaced apart from each other by 100 nm along the length of the magnetic element 2.

The magnetic domain walls 6 present in the magnetic element 2 are head-to-head transverse domain walls 6 with negative chirality and tail-to-tail transverse domain walls 6 with positive chirality. By applying an asymmetric perpendicular magnetic field pulse with an amplitude of 100 mT and a pulse profile as schematically indicated in Figs. 10(a) and (b) and specified above, i.e., with a rise time of 100 ps, a duration of 3 ns and a fall time of 3 ns, a synchronous motion of the two and three domain walls, respectively, from initial pairs of notches 8 to adjacent pairs of notches 8 was observed.

These simulation results further demonstrate that the magnetic device and the method of the invention can be advantageously used for the controlled synchronous motion of multiple domain walls 6.

## Claims

1. A magnetic device switchable by magnetic domain wall motion, the magnetic device comprising
   a magnetic element (2), wherein, in operation of the magnetic device,
   a plurality of magnetic domains (4) are present in the magnetic element (2),
   the magnetic domains (4) are arranged adjacent to each other,
   the magnetisations of the magnetic domains (4) are oriented so that the magnetisation directions are aligned parallel to a plane,
   the magnetisations of adjacent magnetic domains (4) are oriented in different directions from each other, and adjacent magnetic domains (4) are separated from each other by a magnetic domain wall (6), and
   a magnetic pulse application device (10) which is configured to apply magnetic field pulses to at least a portion of the magnetic element (2) in a direction perpendicular to the plane.

2. The magnetic device according to claim 1, wherein the magnetic pulse application device (10) is configured to apply asymmetric magnetic field pulses to the at least a portion of the magnetic element (2), wherein, for each asymmetric magnetic field pulse, a rise time of the asymmetric magnetic field pulse is different from a fall time of the asymmetric magnetic field pulse.

3. The magnetic device according to claim 2, wherein, for each asymmetric magnetic field pulse, the fall time of the asymmetric magnetic field pulse is longer than the rise time of the asymmetric magnetic field pulse.

4. The magnetic device according to claim 3, wherein, for each asymmetric magnetic field pulse, the fall time of the asymmetric magnetic field pulse is 1.5 times or more longer than the rise time of the asymmetric magnetic field pulse.

5. The magnetic device according to any one of the preceding claims, wherein a rise time of each of the magnetic field pulses is in the range of 100 ps to 1 ns.

6. The magnetic device according to any one of the preceding claims, wherein a duration of each of the magnetic field pulses is in the range of 0.1 ns to 20 ns.

7. The magnetic device according to any one of the preceding claims, wherein an amplitude of each of the magnetic field pulses is in the range of 1 mT to 300 mT.

8. The magnetic device according to any one of the preceding claims, wherein the magnetic element (2) comprises at least one domain wall pinning site for pinning a magnetic domain wall (6).

9. The magnetic device according to claim 8, wherein the at least one domain wall pinning site is formed by a geometrical variation of the magnetic element (2) and/or a variation of one or more of the magnetic properties of the magnetic element (2).

10. The magnetic device according to claim 8 or 9, wherein the magnetic element (2) comprises a plurality of domain wall pinning sites for pinning magnetic domain walls (6), the domain wall pinning sites being spaced apart from each other.

11. The magnetic device according to any one of the preceding claims, wherein the thickness of the magnetic element (2) is in the range of 1 to 30 nm and/or the width of the magnetic element (2) is in the range of 10 to 2000 nm.

12. The magnetic device according to any one of the preceding claims, wherein the magnetic element (2) forms a closed loop.

13. The magnetic device according to any one of the preceding claims, further comprising at least one magnetic field sensor (12) for detecting the magnetisation in at least a portion of the magnetic element (2).

14. The magnetic device according to any one of the preceding claims, further comprising a magnetisation switching device (14) for switching the magnetisation direction in one or more of the magnetic domains (4).

15. A method of operating the magnetic device according to any one of the preceding claims, the method comprising applying one or more magnetic field pulses to the at least a portion of the magnetic element (2) in the direction perpendicular to the plane.

(a)

(b)

Fig. 1

Fig. 2

Fig. 3

Fig. 4

Fig. 5

Fig. 6

Fig. 7

Fig. 8

Fig. 9

Fig. 10

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KUNZ ANDREW ET AL: "Application of local transverse fields for domain wall control in ferromagnetic nanowire arrays", APPLIED PHYSICS LETTERS, AIP, AMERICAN INSTITUTE OF PHYSICS, MELVILLE, NY, US, vol. 101, no. 19, 5 November 2012 (2012-11-05), pages 192402-192402, XP012167951, ISSN: 0003-6951, DOI: 10.1063/1.4766173 [retrieved on 2012-11-06] | 1,5,6, 8-15 | INV. G11C19/08 |
| Y | * the whole document * | 7 | |
| Y | KUNZ ANDREW ET AL: "Fast domain wall motion in nanostripes with out-of-plane fields", APPLIED PHYSICS LETTERS, AIP, AMERICAN INSTITUTE OF PHYSICS, MELVILLE, NY, US, vol. 93, no. 8, 26 August 2008 (2008-08-26), pages 82503-82503, XP012113656, ISSN: 0003-6951, DOI: 10.1063/1.2976678 * the whole document * | 1-15 | |
| X | US 5 179 532 A (ONO TAKEO [JP] ET AL) 12 January 1993 (1993-01-12) | 1-4 | TECHNICAL FIELDS SEARCHED (IPC) G11C |
| Y | * column 2; figures 1-2 * | 1-15 | |

The present search report has been drawn up for all claims

| Place of search | Date of completion of the search | Examiner |
|---|---|---|
| Munich | 16 May 2013 | Havard, Corinne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 19 9318

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2013

| Patent document cited in search report | Publication date | Patent family member(s) | Publication date |
|---|---|---|---|
| US 5179532 A | 12-01-1993 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6834005 B

- WO 2007132174 A

**Non-patent literature cited in the description**

- **STUART S.P. PARKIN et al.** Magnetic Domain-Wall Racetrack Memory. *Science,* 2008, vol. 320, 190, http://www.sciencemag.org/content/suppl/2008/04/10/320.5873. 190.DC1.html
- **C.-Y. YOU et al.** Analytic expression for the temperature of the current-heated nanowire for the current-induced domain wall motion. *Applied Physics Letters,* 2006, vol. 89, 222513
- **C.-Y. YOU et al.** Temperature increment in a current-heated nanowire for current-induced domain wall motion with finite thickness insulator layer. *Applied Physics Letters,* 2007, vol. 91, 022507
- **D. ILGAZ et al.** Selective domain wall depinning by localized Oersted fields and Joule heating. *Applied Physics Letters,* 2008, vol. 93, 132503
- Domain-Wall Dynamics in Nanowires and Nanostrips. **A. THIAVILLE et al.** Spin Dynamics in Confined Magnetic Structures III. Springer, 2006
- **J-Y. LEE et al.** Remarkable enhancement of domain-wall velocity in magnetic nanostripes. *Applied Physics Letters,* 2007, vol. 91, 122513

- **O. BOULLE et al.** Current-induced domain wall motion in nanoscale ferromagnetic elements. *Materials Science and Engineering,* 2011, vol. R 72, 159
- **C. SCHIEBACK et al.** Numerical investigation of spin-torque using the Heisenberg model. *Eur. Phys. J. B,* 2007, vol. 59, 429-433
- **T. A. MOORE et al.** Magnetic-field-induced domain-wall motion in permalloy nanowires with modified Gilbert damping. *Physical Review B,* 2010, vol. 82, 094445
- **S.-M. AHN et al.** Detection of the static and kinetic pinning of domain walls in ferromagnetic nanowires. *Applied Physics Letters,* 2009, vol. 95, 152506
- **L. THOMAS et al.** Resonant Amplification of Magnetic Domain-Wall Motion by a Train of Current Pulses. *Science,* 2007, vol. 315, 1553
- **L. THOMAS et al.** Oscillatory dependence of current-driven magnetic domain wall motion on current pulse length. *Nature,* 2006, vol. 443, 197
- **D. BEDAU et al.** Detection of Current-Induced Resonance of Geometrically Confined Domain Walls. *Physical Review Letters,* 2007, vol. 99, 146601